(19) Europäisches Patentamt
European Patent Office
Office européen des brevets

(11) EP 1 533 908 A1

(12) EUROPEAN PATENT APPLICATION
published in accordance with Art. 158(3) EPC

(43) Date of publication:
25.05.2005 Bulletin 2005/21

(51) Int Cl.⁷: H03M 13/29, G11B 20/18

(21) Application number: 03794122.6

(86) International application number:
PCT/JP2003/010953

(22) Date of filing: 28.08.2003

(87) International publication number:
WO 2004/023664 (18.03.2004 Gazette 2004/12)

(84) Designated Contracting States:
AT BE BG CH CY CZ DE DK EE ES FI FR GB GR
HU IE IT LI LU MC NL PT RO SE SI SK TR

(30) Priority: 30.08.2002 JP 2002255778

(71) Applicant: FUJITSU LIMITED
Kawasaki-shi, Kanagawa 211-8588 (JP)

(72) Inventor: UENO, Hiroaki c/o FUJITSU LIMITED
Kawasaki-shi, Kanagawa 211-8588 (JP)

(74) Representative: Sunderland, James Harry et al
Haseltine Lake & Co.,
Imperial House,
15-19 Kingsway
London WC2B 6UD (GB)

(54) DECODING DEVICE

(57) A reproducing apparatus comprising a reproducing head (18) for reproducing encoded data from a recording medium, an internal code APP circuit (22) for decoding an internal code of the encoded data, and an external code APP circuit (23) for decoding an external code and outputting the result as preliminary information of the internal code, further comprises a σ setting circuit (21) for setting a σ value to the internal code APP circuit (22), and an error rate calculating circuit (29) for calculating an error rate. The σ setting circuit (21) varies the σ value. The error rate calculating circuit (29) calculates the error rate of each σ value. Based on the error rate, the σ setting circuit (21) determines the σ value at which good error rate is provided as the optimal σ value, and sets it to the internal code APP circuit (22).

FIG. 2

EP 1 533 908 A1

## Description

### Technical Field

The present invention relates to a repetitive decoding method. More particularly, the present invention relates to a suitable technology for obtaining parameters required for the repetitive decoding method.

### Background Art

An ultimate proposition of the coding theory is to approach the theoretical characteristic limit (Shannon limit). In 1993, Berrou presented a turbo code having a decoding error rate which approaches the Shannon limit. At present, intensive studies are made as to the turbo code and its upper concept, a convolutional code.

The convolutional code is decoded by a maximum likelihood decoding (including viterbi decoding), a repetitive decoding or the like.

The maximum likelihood decoding calculates conditional probability in relation to all transmission code words x in a receiving signal series y such that the code words with maximum probability among all transmission code words are to be input information series u. Therefore, it is possible to minimize the block error rate. However, a bit error rate (BER) is not always minimized, which is a problem. In the viterbi decoding, it is essentially impossible to decode the turbo code.

The repetitive decoding is preferable in that the bit error rate is minimized. In addition, in the repetitive decoding, it is possible to decrease about 5 to 6 decibels (dBs) in the data transmission channel signal to noise ratio (S/N) in order to provide the similar level of the bit error rate as the maximum likelihood decoding. However, in the repetitive decoding, it is required to calculate statistic probability of all paths on path-metric each having maximum posteriori probability, and it requires the data transmission channel value for calculation. The data transmission channel value is calculated using an S/N value or a σ value in the data transmission channel. In the maximum likelihood decoding, an error between a receiving signal and a predictive signal at each branch is accumulated, and a path where the accumulated error signal becomes small at a connecting point of the path-metric is selected as a maximum likelihood path. Accordingly, the maximum likelihood path can be selected without calculating the S/N value or the σ value in the data transmission channel.

When the repetitive decoding is applied to a recording and reproducing apparatus, it is required to optimize recording and reproducing parameters under worse conditions of the data transmission channel S/N as compared with the conventional conditions.

### Disclosure of Invention

A first object of the present invention is to obtain the S/N value or the σ value of the data transmission channel rapidly for calculating the data transmission channel value in the repetitive decoding, thereby solving the above-mentioned problems. A second object of the present invention is to obtain the recording and reproducing parameters and the like rapidly in accordance with the S/N value or the σ value of the data transmission channel, when the repetitive decoding is applied to the recording and reproducing apparatus.

In order to achieve the above-mentioned objects, one aspect of the present invention is a method of decoding data by decoding an internal code of encoded data, decoding an external code of the encoded data, and using the decoded external code as preliminary information of the internal code upon decoding the internal code, the method comprising: varying a numerical value required for calculating a data transmission channel value upon decoding the internal code, calculating an error rate in each numerical value, and determining an optimal numerical value to be used upon decoding the internal code based on the error rate.

In the repetitive decoding, the error rate has a performance characteristic that is insensitive to the change in the numerical value required for calculating the data transmission channel value. Accordingly, it is considered that the numerical value is not necessarily calculate accurately. The numerical value required for calculating the data transmission channel value is not calculated, but is varied to calculate the error rate. Based on the error rate, the optimal numerical value to be used upon decoding can be determined. Thus, the numerical value can be obtained rapidly.

In the present decoding method, the numerical value is, for example, a signal to noise ratio, or a square root of an inverse number of the signal to noise ratio.

In the present decoding method, the optimal numerical value may be the value obtained when the error rate calculated is optimal, or may be an average value of the maximum and minimum values of the numerical value obtained when the predetermined error rate is obtained.

In the repetitive decoding, the S/N value required when the data transmission channel S/N is greater than the actual value, and the S/N value required when the data transmission channel S/N is smaller than the actual value change substantially symmetrically at a center of 0 (zero) calculation error of the data transmission channel value. It is contemplated that an average value of the maximum and minimum values of the data transmission channel S/N that provides the same S/N required is proximate the value of the data transmission channel S/N when there is no calculation error. The latter determination method is based on this conception. When the error rate is good, it requires more time to calculate the error rate as compared with the case when the error rate is bad. In the case of the latter determination method, it is unnecessary to calculate the optimal error rate, and only the maximum and minimum values that afford the bad error rate (upper limit error rate) are calculated, thereby reducing the time required for determining the optimal value.

The present decoding method may further comprising the step of varying a repetition time for decoding when the error rate is calculated.

The repetitive decoding method has a performance characteristic that the error rate gets worse, when the repetition time is decreased. As described above, when the error rate is bad, the time required for calculating the error rate is shorter than that when the error rate is good. Accordingly, when the optimal value is determined, the repetition time is varied, specifically the repetition time is reduced, to calculate the error rate, thereby reducing the time required for determining the optimal value.

The present decoding method may further comprise: varying a recording compensation value for use in recording data in a recording medium, calculating the error rate of each recording compensation value using a numerical value other than the optimal numerical value, and determining the recording compensation value at which the error rate is optimal as an optimal recording compensation value. When the error rate is calculate using the numerical value other than the optimal numerical value, it is degraded. According to the present method, it is possible to shorten the time required for calculating the error rate as compared with the case that the error rate is calculated using the optimal value. Thus, the optimal recording compensation value can be rapidly obtained.

The present decoding method may further comprise: varying an equalizer coefficient for use in equalizing data reproduced from the recording medium, calculating an error rate of each equalizer coefficient using the numerical value other than the optimal numerical value, and determining the equalizer coefficient at which the error rate is optimal as an optimal equalizer coefficient. According to the present method, the optimal recording compensation value can be rapidly obtained.

When the optimal recording compensation value is obtained or when the optimal equalizer coefficient is determined, the repetition time may be varied, more specifically the repetition time may be reduced. It is also possible to shorten the time required for obtaining the optimal recording compensation value or the optimal equalizer coefficient.

The present decoding method may further comprise: recording the optimal numerical value in a recording means, and reading-out the numerical value from a means for recording the numerical value upon decoding.

The recording means may record the optimal numerical value corresponding to the environmental temperature. Since the data transmission channel S/N is changed corresponding to the environmental temperature, the optimal numerical value is recorded in the recording means corresponding to the respective environmental temperature, whereby the code can be decoded using the optimal numerical value at the matched environmental temperature.

Instead of recording the numerical value corresponding to the environmental temperature, the numerical value at reference temperature and a difference value of the numerical value corresponding to the difference between the environmental temperature and the reference temperature may be recorded in the recording means. In this case, the same advantages can be provided.

Instead of recording the optimal numerical value in the recording means, the optimal numerical value may be recorded in a recording medium together with other data, and the optimal numerical value may be read-out upon reproducing the data.

Another aspect of the present invention is a decoding circuit or a decoding apparatus comprising: an internal code decoding circuit for decoding an internal code of the data, an external code decoding circuit for decoding an external code of the data and inputting the decoded result into the internal code decoding circuit as a preliminary information of the internal code, an error rate calculating circuit for calculating an error rate, and a numerical value setting circuit for setting a numerical value required for calculating a data transmission channel to the internal code decoding circuit, wherein the error rate calculating circuit calculates the error rate of each numerical value varied by the numerical value setting circuit, and the numerical value setting circuit determines an optimal numerical value to be set in the internal code decoding circuit based on the error rate calculated.

The decoding circuit or the decoding apparatus performs the same procedures as described in the decoding method, whereby the same actions and advantages are provided. Thus, the above-mentioned problems can be solved. Furthermore, a data reproducing apparatus utilizing the decoding apparatus or the decoding circuit provides the same actions and advantages. Thus, the above-mentioned problems can be solved.

There is a program for making a processor perform the same procedures as those performed in the decoding method. The above-mentioned problems can be solved by executing the program with the processor. Also, the above-mentioned problems can be solved by reading-out the program from the recording medium on which the program is recorded, and by executing the program.

**Brief Description of the Drawings**

Fig. 1 shows a non-recording model;
Fig. 2 is a block diagram showing a recording and reproducing apparatus according to the present invention;
Fig. 3 is a graph showing the calculation error of the data transmission channel S/N vs. the required data transmission channel S/N;
Fig. 4 is a graph showing the calculation error of the data transmission channel S/N vs. the average error bit numbers;
Fig. 5 is a graph showing the data transmission channel S/N vs. the bit error rate;
Fig. 6 is a graph showing the repetition time and the bit error rate in one embodiment; and
Fig. 7 is a graph showing the repetition time and the bit error rate in another embodiment.

**Best Mode of Carrying Out the Invention**

Referring to figures, embodiments of the present invention will be described. Apparatus and the like with the same reference numbers refer to the same apparatus and the like. The explanation thereof is not repeated.

Firstly, the convolutional code and the repetitive decoding method will be described. The convolutional code is roughly classified into the turbo code and a low density parity check code. The turbo code is classified into a parallel concatenated convolutional code (PCCC) and a serial concatenated convolutional code (SCCC) depending on a connection type of a coding circuit. A repetitive decoding method is known to decode the convolutional code.

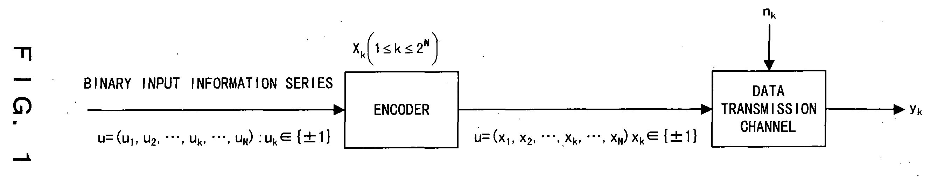

Taking the turbo coding as an example, it will be explained that the data transmission channel value is required in the repetitive decoding method, and that the data transmission channel value can be calculated using the data transmission channel S/N. For explanation, a non-recording data transmission channel model shown in Fig. 1 is supposed. In the model shown in Fig. 1, binary input information series $u_k$ is encoded, whereby $x_k$ is selected from coding as many as 2 raised to (N)th power and is transmitted to the data transmission channel to be receiving signal series $y_k$.

In the repetitive decoding method, it is required to calculate a log likelihood ratio (LLR) $L(\hat{u}_k)$ of a posteriori probability (APP) $P(u_k|y)$.

$$L(\hat{u}_k) = L(u_k|y) = \ln P(u_k = +1|y) / P(u_k = -1|y) \tag{1}$$

A posteriori probability can be represented by the equations (2) and (3) in accordance with Bayes's theorem.

$$P(u_k = +1|y) = P(u_k = +1)P(y|u_k = +1) / P(y) \tag{2}$$

$$P(u_k = -1|y) = P(u_k = -1)P(y|u_k = -1) / P(y) \tag{3}$$

In the turbo code, restraining conditions of the receiving signal series y are provided by an encoder. The receiving signal series y in the second terms at the right sides of the equations (2) and (3) is considered separately as shown in the equation (4). The equation (4) represents the case that $\hat{u}_k = +1$.

$$P(y|u_k = +1) = P(y_k|u_k = +1)P(y \text{ except } y_k|u_k = +1) \tag{4}$$

The equations (2) and (3) are changed to the following equations (5) and (6).

$$P(u_k = +1|y) = P(u_k = +1) \, P(y_k|u_k = +1) \, P(y \text{ except } y_k|u_k$$

$$= +1) / P(y) \tag{5}$$

$$P(u_k = -1|y) = P(u_k = -1) \, P(y|u_k = -1) \, P(y \text{ except } y_k|u_k =$$

$$-1) \, / \, P(y) \qquad\qquad (6)$$

The $L(\hat{u}_k)$ is represented by the equation (7).

$$L(\hat{u}_k) = \ln[P(u_k = +1) \, / \, P(u_k = -1) \cdot P(y_k |u_k = +1) \, / \, P(y_k |u_k$$

$$= -1) \cdot P(y \text{ except } y_k|u_k = +1) \, / \, P(y \text{ except } y_k|u_k = -1)]$$

$$= L(u_k) + L_c(y_k) + L_{ext}(\hat{u}_k) \qquad\qquad (7)$$

where $L(u_k)$ is a log ratio of a priori probability P $(u_k)$ that is a known occurrence probability relating to $u_k = +1$ and $u_k = -1$.

$Lc(y_k)$ is a log ratio of the data transmission channel obtained from the receiving signal $y_k$.

$L_{ext}(\hat{u}_k)$ is external information obtained from the restriction of the code in relation to $u_k$.

Accordingly, as apparent from the equation (7), the data transmission channel value is required in the repetitive decoding method. The noise is additive white Gaussian noise (AWGN). When there is no noise, the log value of the data transmission channel $L_c(y_k)$ when $y_k \in \{\pm 1\}$ can be represented by the following equation (8):

$$L_c(y_k) = \ln(\exp(-(y_k-1)^2/2\sigma^2) \, / \, \exp(-(y_k-1)^2/2\sigma^2)) =$$

$$2y_k/\sigma^2 \qquad\qquad (8)$$

The $\sigma^2$ is an inverse number of the data transmission channel S/N. Therefore, it requires to know the $\sigma$ or the data transmission channel S/N for calculating the data transmission channel value.

Based on the above, the present invention will be described below. As an example, the present invention is applied to a recording and reproducing apparatus and the SCCC is used as the turbo code. It should be understood, however, that there is no intention to limit the invention to the particular embodiments described.

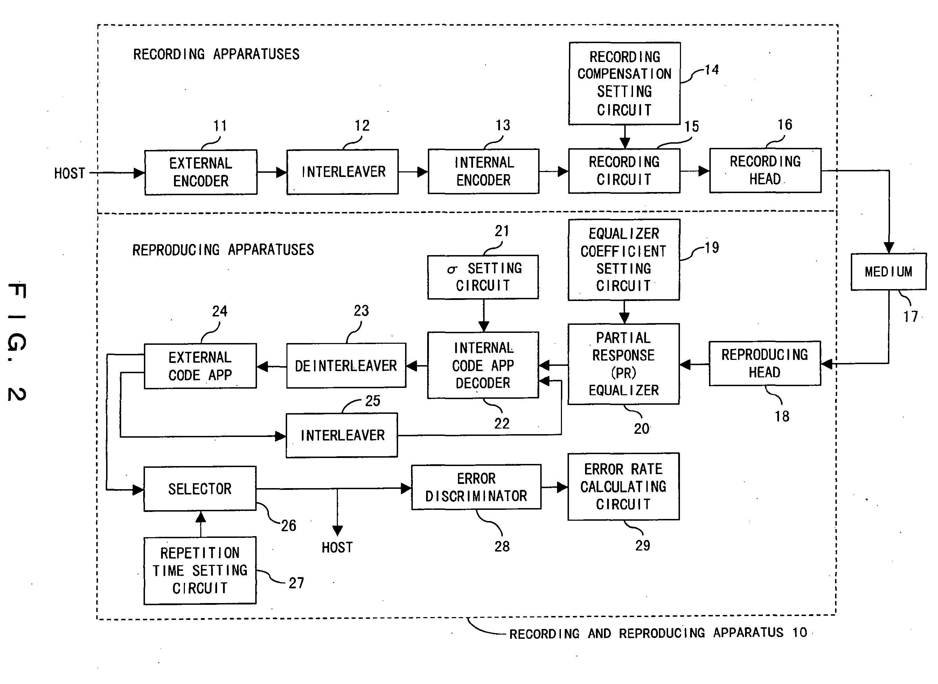

Fig. 2 is a block diagram showing a recording and reproducing apparatus according to the present invention. As shown in Fig. 1, a recording and reproducing apparatus 10 comprises recording apparatuses and reproducing apparatuses. The recording and reproducing apparatus 10 comprises the recording apparatuses including an external encoder 11, an interleaver 12, an internal encoder 13, a recording compensation setting circuit 14, a recording circuit 15 and a recording head 16, and the reproducing apparatuses including a reproducing head 18, an equalizer coefficient setting circuit 19, a partial response (PR) equalizer 20, a $\sigma$ setting circuit 21, an internal code APP (a posteriori probability) decoder 22, a deinterleaver 23, an external code APP decoder 24, an interleaver 25, a selector 26, a repetition time setting circuit 27, an error discriminator 28 and an error rate calculating circuit 29. The external encoder 11 and the internal encoder 13 are both recursive systematic convolutional encoders (RSC).

Firstly, the recording apparatuses will be described. The external encoder 11 receives data to be recorded in a medium 17 from a host system, and encodes the data. The interleaver 12 displaces randomly an array of codes outputted from the external encoder 11. The internal encoder 13 further encodes the codes displaced by the interleaver 12. Since the interleaver 12 is disposed between the external encoder 11 and the internal encoder 13, even if output series of the external encoder 11 have a minimum hamming weight, it is possible to decrease the probability that the output series of the internal encoder 13 again have the minimum hamming weight.

Thus-encoded data are outputted to the recording head 16 via the recording circuit 15. The recording head 16 records the encoded data into the medium 17. The recording circuit 15 comprises a recording compensation circuit (not shown) for performing recording compensation. A recording compensation value of the recording compensation circuit is set by the recording compensation setting circuit 14.

Then, the reproducing apparatuses will be described. The reproducing head 18 read-in the encoded data from the recording medium 17. The PR equalizer 20 removes the effect of intersymbol interference from the encoded data read-in by the reproducing head 18, and outputs the results to the internal code APP circuit 22. The equalizer coefficient setting circuit 19 sets a coefficient used upon equalization to the PR equalizer 20. The internal code APP circuit 22 computes maximum posteriori probability of the internal code. As mentioned above, the data transmission channel value is required for decoding.

The σ setting circuit 21 sets σ required for calculating the data transmission channel value at the internal code APP circuit 22. The σ setting circuit 21 can change the σ value. An inverse number of $\sigma^2$ equals to the data transmission channel S/N. Therefore, the σ setting circuit 21 may set the data transmission channel S/N. In the following description, the σ setting circuit 21 sets the σ value, but there is no intention to limit the invention thereto. Instead of the σ setting circuit 21, a data transmission channel S/N setting circuit for setting and changing the data transmission channel S/N may be disposed.

The deinterleaver 23 performs reverse displacement as the interleaver 12. The external code APP decoder 24 computes maximum posteriori probability of the external code. The interleaver 25 displaces randomly an array of decoded results by the external code APP decoder 24. The results are inputted to the internal code APP circuit 22 and the selector 26. The outputs from the external code APP circuit 24 are used as preliminary information in the internal code APP circuit 22.

The selector 26 outputs as a discrimination result the outputs from the external code APP circuit 24 under the conditions that the repetition time reach the upper limit, the log likelihood ratio per repetition time is sufficiently great and the like. The repetition time is set by the repetition time setting circuit 27. The discrimination result from the selector 26 is outputted to the host system and the error discriminator 28.

The error discriminator 28 discriminates the presence or the absence of an error in the discrimination result. The error rate calculating circuit 29 calculates an error rate such as a bit error rate, an event error rate and the like based on an error discrimination result by the error discriminator 28.

As described above, in the repetitive decoding method, it is required to calculate the data transmission channel value. However, it is difficult to calculate the data transmission channel value, in other words, to provide the data transmission channel S/N (or σ value) by calculation when the data transmission channel value is calculated. According to the present invention, the data transmission channel S/N (or σ value) is not calculated, but the σ value is varied by the σ setting circuit 21, and the error rate in each σ value is calculated by the error rate calculating circuit 29. The σ setting circuit 21 sets the σ value obtained when the error rate becomes good as the optimal σ value to be used upon decoding to the internal code APP circuit 22 of the recording and reproducing apparatus 10. Thus, it is possible to shorten the time required for calculating the data transmission channel S/N value. This method is based on the performance characteristic of the recording and reproducing apparatus 10 as described later.

According to the present invention, the σ setting circuit 21 sets a σ value other than the optimal σ value to the internal code APP circuit 22, and the recording compensation setting circuit 14 varies the recording compensation value. The error rate calculating circuit 29 calculates the error rate in each recording compensation value. The recording compensation setting circuit 14 sets the recording compensation value obtained when the error rate becomes the optimal value as an optimal recording compensation value to the recording circuit 15. Thus, it is possible to shorten the time required for calculating the optimal recording compensation value.

According to the present invention, the σ setting circuit 21 sets a σ value other than the optimal σ value to the internal code APP circuit 22, and the equalizer coefficient setting circuit 19 varies the equalizer coefficient. The error rate calculating circuit 29 calculates the error rate in each equalizer coefficient. The equalizer coefficient setting circuit 19 sets the equalizer coefficient obtained when the error rate becomes optimal as an optimal equalizer coefficient to the PR equalizer 20. Thus, it is also possible to shorten the time required for calculating the equalizer coefficient.

When the optimal σ value, the optimal recording compensation value and the optimal equalizer coefficient are calculated, the repetition time setting circuit 27 may vary the repetition time in the repetitive decoding. Thus, it is also possible to shorten the time required for calculating the optimal σ value, the optimal recording compensation value and the optimal equalizer coefficient. This method is also based on the performance characteristic of the recording and reproducing apparatus 10 as described later.

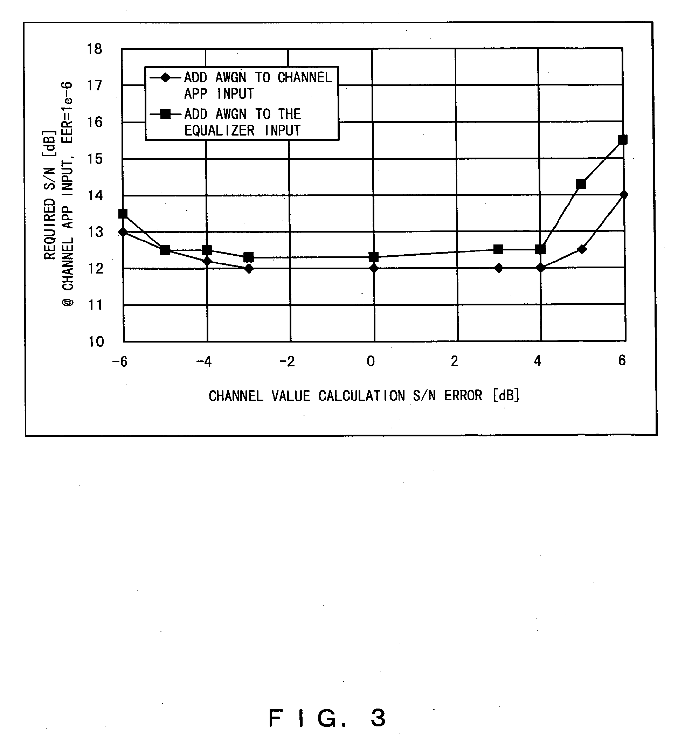

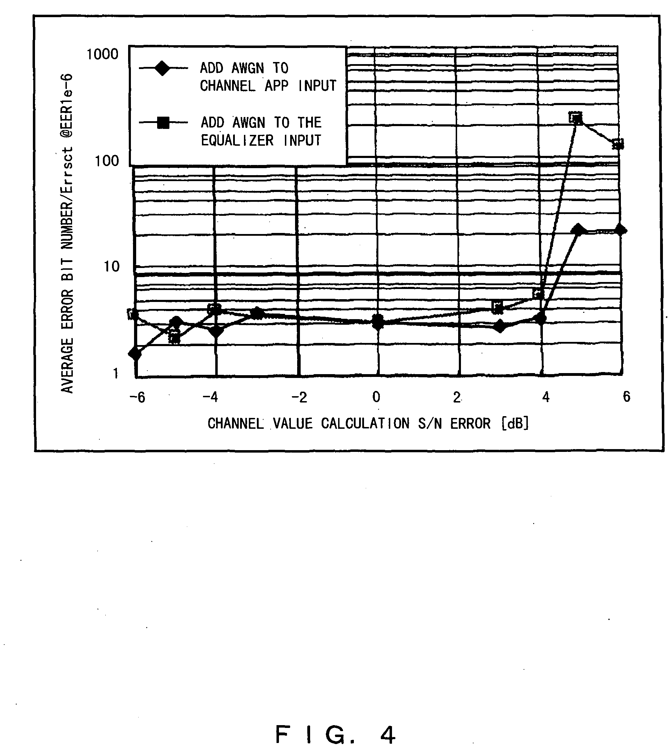

Referring to Figs. 3 to 7, the performance characteristic of the recording and reproducing apparatus 10 will be described. Referring to Figs. 3 and 4, the sensitivity of the decoding performance against the error of the data transmission channel S/N will be described. The simulation conditions are as follows:

  Input to the internal code APP circuit EER = $10^{-6}$
  Decoding time : 5
  Block length : 4096

In each Figure, the simulated result is shown in diamond shape marks when the additive white Gaussian noise (AWGN) is added to the input of the internal code APP circuit, and the simulated result is shown in square shape marks when the AWGN is added to the input of the PR equalizer. The error event ratio (EER) is defined by the following equation (9):

$$EER = (error\ block\ number) / (decoding\ block\ number$$

x 4096 bits) (9)

Fig. 3 shows the change in the S/N required for satisfying EER = $10^{-6}$, i.e., the required S/N, to the calculation error of the data transmission channel S/N in the recording and reproducing apparatus 10. In Fig. 3, the horizontal line represents an error between the data transmission channel S/N used when the data transmission channel value is calculated and the actual data transmission channel S/N (unit: dB), and the vertical line represents the required S/N. As shown in Fig. 3, it is found that when the error of the data transmission channel S/N is less than +-4 dB, the required S/N is substantially uniform, but when the error is greater than about +- 4 dB, the required S/N is significantly increased. In other words, when the error between the actual data transmission channel S/N and the data transmission channel S/N set at the recording and reproducing apparatus 10 is less than about +-4 dB, the required S/N is substantially not changed. Therefore, it can be concluded that it is not necessarily required that the data transmission channel S/N set accurately equals to the actual S/N in order to satisfy ERR = $10^{-6}$. The data transmission channel S/N can be represented using the σ value. Therefore, the actual σ value does not necessarily equal to the σ value set at the recording and reproducing apparatus 10 for providing the required S/N.

Fig. 4 shows the change in the average error bit numbers at ERR = $10^{-6}$ against the calculation error of the data transmission channel S/N. In Fig. 4, the horizontal line represents the error of the data transmission channel S/N (unit: dB), and the vertical line represents the average error bit numbers (unit: number/error script). As shown in Fig. 4, it is found that when the data transmission channel S/N is smaller than the actual, the error bit numbers are not increased, but when it is greater than 3 dB, the error bit numbers are significantly increased. As shown in Figs. 3 and 4, when the error between the actual data transmission channel S/N and the data transmission channel S/N set is less than about +-3 dB, the required S/N and the error rate are not significantly degraded.

According to the present invention, the σ setting circuit 21 vary the σ value set at the internal code APP circuit 22, and the error rate calculating circuit 29 calculates the error rate in each σ value. The σ setting circuit 21 determines the σ value obtained when the error rate is best as the optimal σ value, and sets the optimal σ value at the internal code APP circuit 22. Thus-determined optimal σ value does not always equal to the actual σ value. However, as the above-mentioned simulated results reveal, the required S/N is insensitive to the calculation error of the data transmission channel S/N. Therefore, it is considered that no problems occur in the recording and reproducing apparatus 10.

As shown in Fig. 3, the S/N value required when the data transmission channel S/N is greater than the actual value, and the S/N value required when the data transmission channel S/N is smaller than the actual value change substantially symmetrically at a center of 0 (zero) calculation error of the data transmission channel value. It is contemplated that an average value of the maximum and minimum values of the data transmission channel S/N that provide the same S/N required is proximate the value of the data transmission channel S/N when there is no calculation error.

According to the present invention, the σ setting circuit 21 varies the σ value set at the internal code APP circuit 22. The error rate calculating circuit 29 determines the maximum and minimum σ values obtained when the predetermined upper limit error rate is satisfied. The σ setting circuit 21 may take the average value of the maximum and minimum σ values as the optimal σ value.

When the error rate is good, it requires more time to calculate the error rate. Therefore it requires more time to calculate the error rate by varying the σ value, and to determine the σ value that provides the optimal error rate among the error rates calculated. When the error rate is good, instead of calculating the optimal error rate, the optimal σ value is determined based on the maximum and minimum σ values that afford the bad error rate (upper limit error rate), thereby reducing the time required for determining the optimal σ value.

Thus-determined optimal σ value may be recorded in a recording means (not shown) of the recording and reproducing apparatus 10. The σ setting circuit 21 may read-out the optimal σ value from the recording means upon using the recording and reproducing apparatus 10, and may set it to the internal code APP circuit 22. Alternatively, the optimal σ value may be recorded in the recording medium 17. When the recording and reproducing apparatus 10 reproduce the data recorded in the recording medium 17, the σ setting circuit 21 may read-out the optimal σ value from the recording medium 17, and may set it to the internal code APP circuit 22.

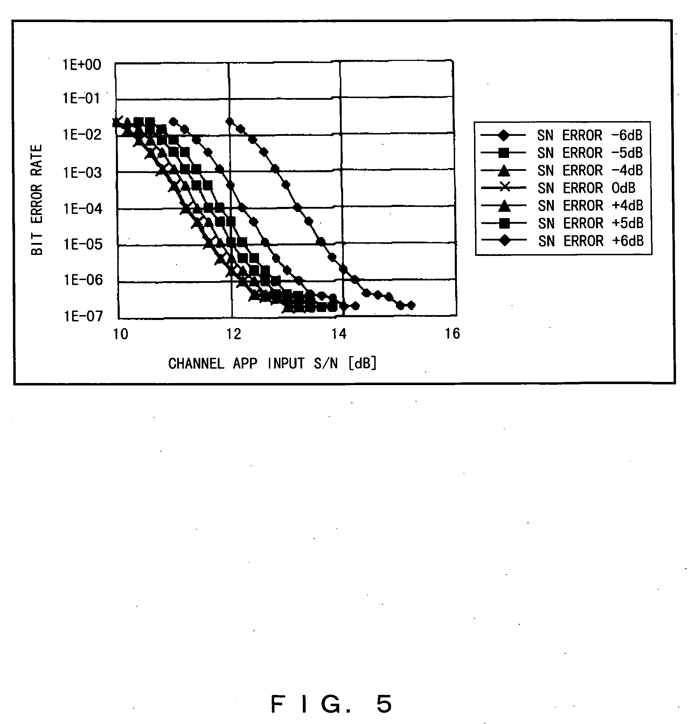

Referring to Fig. 5, there will be described a change in the bit error rate against the data transmission channel S/N when the calculation errors exist in different data transmission channels S/N. In Fig. 5, the horizontal line represents the S/N in the input of the internal code APP circuit (unit: dB), and the vertical line represents the bit error rate. The X marks represent the simulated result when no calculation error exists, and triangle-, square- and diamond-shaped marks represent the simulated results when the errors are 4 dB, 5 dB and 6 dB, respectively. The white marks represent the case that the S/N calculated exceeds the actual value, and the black marks represent the case that the S/N calculated is lower than the actual value. As shown in Fig. 5, it is found that when the calculation error of the data transmission channel is about +-4 dB, there is almost no change in the bit error rate. It is also found that the greater the calculation error is, the greater the error rate is.

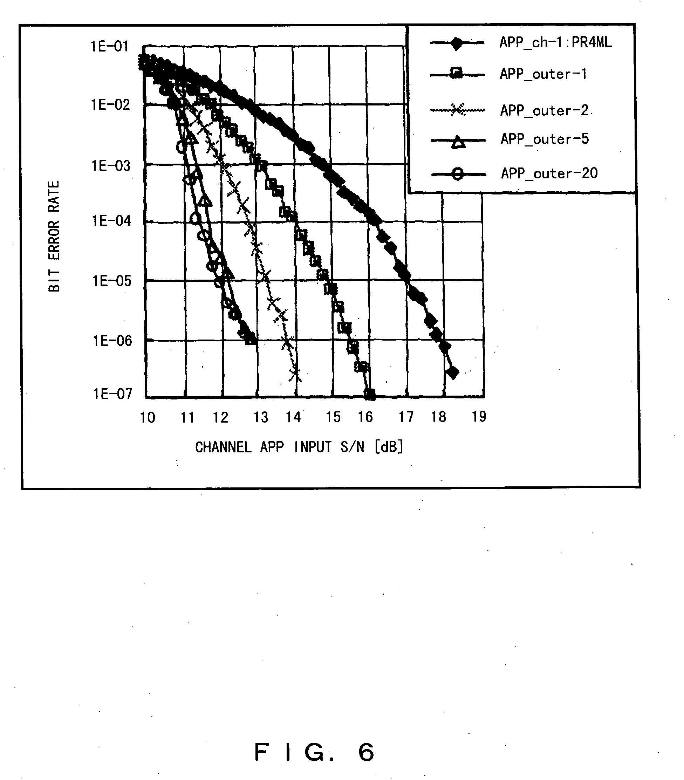

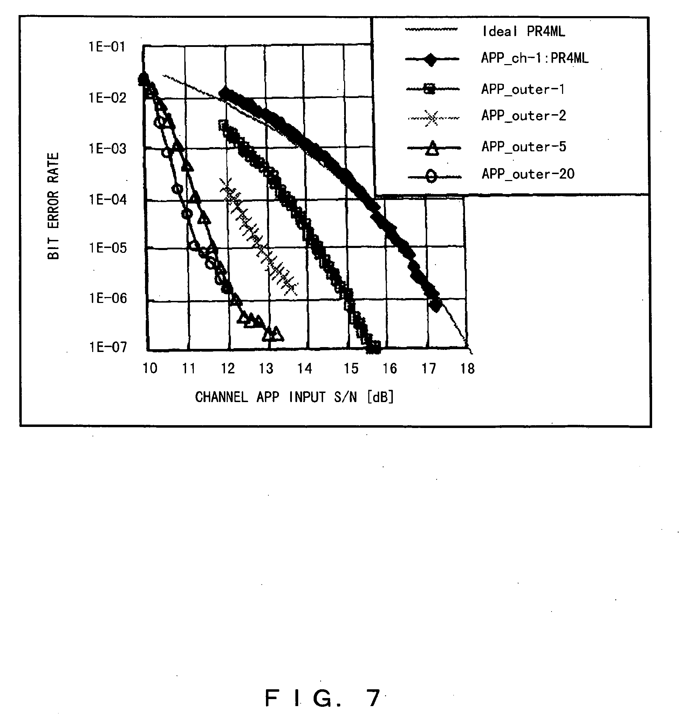

Referring to Figs. 6 and 7, the change in the bit error rate against the repetition time will be described. The simulation conditions are as follows:

Block length : 4096
Encoded ratio : 8/9
Equalizing mode : PR4
RSC encoder : (7,5)oct
Precoder : (5,1)oct
Improved S-random interleaver
Du = 2.5

The bit error rate is defined by the following equation (10) :

$$BER = (\text{error bit number}) / (\text{decoded block number} \times 4096) \tag{10}$$

Fig. 6 shows a comparison of the bit error rate obtained when the data is decoded by superimposing the AWGN to the input of the internal code APP circuit using the repetitive decoding method at different repetition times and the bit error rate obtained when the input is decoded by the maximum likelihood decoding under the above-mentioned simulated conditions. In Fig. 6, the horizontal line represents the S/N in the input of the internal code APP circuit (unit: dB), and the vertical line represents the bit error rate. The diamond marks represent the simulated result when no repetition is made (similar to the maximum likelihood decoding), and square-, X-, triangle-, and round-shaped marks represent the simulated results when the repetition time is 1, 2, 5 and 20, respectively.

As shown in Fig. 6, it is found that the repetitive decoding method gives the decreased bit error rate as compared with that given by the maximum likelihood decoding method irrespective of the repetition time. For example, as shown in Fig. 6, when the bit error rate is $10^{-6}$, the data transmission channel S/N obtained by the repetitive decoding method using one repetition time is improved by about 2 dB as compared with that obtained by the maximum likelihood decoding method.

In the repetitive decoding method, the more the repetition time is, the better the data transmission channel S/N is. For example, as shown in Fig. 6, when the bit error rate is $10^{-6}$, the data transmission channel S/N obtained by the repetitive decoding method using one repetition time is improved by about 2 dB as compared with that obtained by the maximum likelihood decoding method, and the data transmission channel S/N obtained by the repetitive decoding method using 5 repetition times is further improved by about 5.3 dB. However, as the repetition time is increased, the percentage of the decreased bit error rate is decreased. The bit error rate is not so decreased, if the repetition time is over 5 and is further increased. For example, as shown in Fig. 6, the bit error rate is not so changed, when the result obtained by the repetitive decoding method using 5 repetition times is compared with the result obtained by the repetitive decoding method using 20 repetition times.

Fig. 7 shows a comparison of the bit error rate obtained when the data is decoded by inputting a color noise to the internal code APP circuit using the repetitive decoding method at different repetition times and the bit error rate obtained when the data is decoded by the maximum likelihood decoding. In Fig. 7, the horizontal line represents the S/N in the input of the internal code APP circuit (unit: dB), and the vertical line represents the bit error rate, similar to Fig. 6. As shown in Fig. 7, similar to Fig. 6, it is found that the repetitive decoding method gives the excellent bit error rate as compared with that given by the maximum likelihood decoding method. The more the repetition time is, the better the bit error rate of the repetitive decoding method is. The bit error rate is not so improved, if the repetition time is over a certain time.

As shown in Figs. 6 and 7, if the repetition time is small, the bit error rate is degraded. When the error rate is bad, the time required for calculating the error rate is shorten as compared with the case when the error rate is good. Accordingly, when the optimal σ value is determined by either of the above-mentioned two methods, the error rate may be calculated such that the repetition time is set lower than that upon decoding. Thus, it is possible to further shorten the time required for determining the optimal σ value error rate.

Then, there will be described a determining means of the optimal recording compensation value set to the recording circuit 15 of the recording and reproducing apparatus 10. As shown in Fig. 5, when the calculation error of the data transmission channel S/N is increased, the error rate is degraded. Accordingly, after the optimal σ value is determined, a σ value other than the optimal σ value is set, whereby the error rate can be degraded. With the bad error rate, while the recording compensation value is varied by the recording compensation value setting circuit 14, the error rate in each recording compensation value is calculated by the error rate calculating circuit 29. The recording compensation setting circuit 14 sets the recording compensation value that gives the best error rate as the optimal recording compensation value to the recording circuit 15.

When the error rate is bad; the time required for calculating the error rate is shorter than that when the error rate is good. The bad error rate is provided by varying a σ value other than the optimal σ value. The recording compensation value is varied to calculate the error rate, whereby it is possible to shorten the time required for calculating the optimal recording compensation value. Alternatively, the error rate may be degraded by decreasing the repetition time, as described above. With this method, it is possible to shorten the time required for calculating the optimal recording compensation value. The optimal recording compensation value may be determined by varying σ value other than the optimal σ value, and decreasing the repetition time. In this case, it is also possible to shorten the time required for calculating the optimal recording compensation value.

Then, there will be described a determining means of the optimal recording compensation value set to the PR equalizer 20 of the recording and reproducing apparatus 10. The means is substantially similar to the means for determining the optimal recording compensation value as described above. In other words, the bad error rate is provided by varying a σ value other than the optimal σ value and/or by decreasing the repetition time. The equalizer coefficient is varied to calculate the error rate in each equalizer coefficient. The equalizer coefficient that gives the best error rate is determined as the optimal equalizer coefficient. Thus, it is possible to shorten the time required for determining the optimal equalizer coefficient.

Setting of the recording system of the recording and reproducing apparatus 10 will be described. The data transmission channel S/N is changed depending on the environmental temperature. Accordingly, it is required to optimize the σ value set to the internal code APP circuit 22 depending on the environmental temperature.

By changing the environmental temperature, the optimal σ value at each environmental temperature is determined as described above. Then, a table for storing the optimal σ value corresponding to the environmental temperature is formed. The table is stored in the recording medium 17 or a recording means (not shown) such as a memory of the recording and reproducing apparatus 10. When the data recorded in the recording medium 17 is reproduced, a temperature detector (not shown) detects the environmental temperature, and the σ setting circuit 21 reads-out the optimal σ value corresponding to the environmental temperature from the recording medium 17 or the recording means to set the optimal σ value at the internal code APP circuit 22. Thus, the optimal σ value can be rapidly set to the internal code APP circuit 22 corresponding to the environmental temperature.

A reference temperature which is environmental temperature of reference is determined. A table for storing a difference value between the optimal σ value at the reference temperature and the optimal σ value at the environmental temperature is formed. The table may be recorded in the recording medium 17 or the recording means.

Although the embodiments of the present invention have been described, it should be understood that the invention is not to be unduly limited to the embodiments set forth herein, and various modifications and alterations of this invention will be possible.

For example, although the recording and reproducing apparatus 10 utilizes SCCC in the above description, other apparatus may utilize other code. Examples of the other apparatuses include a mobile phone, a broadcast transmitter/receiver and the like. Examples of the other codes include a PCCC, a low density parity check code and the like. When the apparatus is the mobile phone, the broadcast transmitter/receiver, the recording circuit 15, the recording compensation setting circuit 14, the recording head 16, the reproducing head 18, the PR equalizer 20 and the equalizer coefficient setting circuit 19 are not required. Instead, the mobile phone or the broadcast transmitter/receiver comprises a transmitter, an antenna and the like.

A memory (recording medium) may store a program (firmware) for making a processor perform the process; the processor being incorporated in the recording and reproducing apparatus 10; and the process being performed by the σ setting circuit 21, the equalizer coefficient setting circuit 19, the recording compensation setting circuit 14, the repetition time setting circuit 27 and the like.

As described in detail, according to the decoding apparatus, the decoding circuit and the decoding method of the present invention, the S/N value or the σ value of the data transmission channel are not calculated but are varied to calculate the error rate at each S/N value or σ value of the data transmission channel. Based on the error rate, the optimal data transmission channel S/N or the optimal σ value to be used upon decoding is determined. Thus, it is possible to rapidly provide the optimal data transmission channel S/N or the optimal σ value.

The σ value or the repetition time is set to a value other than the optimal value to degrade the error rate. Then, the recording and reproducing parameter is varied and the error rate is calculated at each recording and reproducing parameter. Based on the error rate, the optimal recording and reproducing parameter and the like are determined, whereby it is possible to rapidly provide the recording and reproducing parameter.

**Industrial Applicability**

As described in detail, the decoding apparatus, the decoding circuit and the decoding method according to the present invention are suitable for applying to a reproducing apparatus of a data recorded in a recording medium such as a hard disk, and an apparatus for sending and receiving a encoded data, i.e., a mobile phone and broadcast transmitter/receiver.

**Claims**

1. A method of decoding data by decoding an internal code of encoded data, decoding an external code of the encoded data, and using the decoded external code as preliminary information of the internal code upon decoding the internal code, the method comprising:

   varying a numerical value required for calculating a data transmission channel value upon decoding the internal code,
   calculating an error rate in each numerical value, and
   determining an optimal numerical value to be used upon decoding the internal code based on the error rate calculated.

2. The method according to claim 1, wherein the numerical value is a signal to noise ratio in the transmission channel, or a square root of an inverse number of the signal to noise ratio.

3. The method according to claim 1, wherein the optimal numerical value is the value obtained when the error rate calculated is optimal.

4. The method according to claim 1, wherein the optimal numerical value is an average value of the maximum and minimum values of the numerical value obtained when the predetermined error rate is obtained.

5. The method according to any one of claims 1 to 4, further comprising varying a repetition time for decoding when the error rate is calculated.

6. The method according to claim 5, wherein the error rate may be calculated such that the repetition time is set lower than that upon decoding.

7. The method according to claim 1, further comprising:

   varying a recording compensation value for use in recording data in a recording medium,
   calculating the error rate of each recording compensation value using a numerical value other than the optimal numerical value, and
   determining the recording compensation value at which the error rate is optimal as an optimal recording compensation value.

8. The method according to claim 7, further comprising varying a repetition time for use upon decoding, when the recording compensation value for use in recording data in the recording medium is determined.

9. The method according to claim 1, further comprising:

   varying an equalizer coefficient for use in equalizing data reproduced from the recording medium,
   calculating the error rate of each equalizer coefficient using the numerical value other than the optimal numerical value, and
   determining the equalizer coefficient at which the error rate is optimal as an optimal equalizer coefficient.

10. The method according to claim 9, further comprising varying the repetition time for use upon decoding when the equalizer coefficient for use in equalizing data reproduced from the recording medium is determined.

11. The method according to claim 1, further comprising:

   recording the optimal numerical value in the recording means, and
   reading-out the optimal numerical value from the recording means upon decoding.

12. The method according to claim 11, wherein the optimal numerical value is recorded in the recording means corresponding to environmental temperature.

13. The method according to claim 11, wherein the optimal numerical value at reference temperature which is environmental temperature of reference and a difference value between the optimal numerical value at each environmental temperature and the optimal numerical value at the reference temperature is recorded in the recording means.

14. The method according to claim 1, further comprising:

   recording the optimal numerical value in a recording medium together with the other data, and
   reading-out the numerical value from the recording medium when the other data is reproduced.

15. A decoding circuit for decoding encoded data, comprising:

   an internal code decoding circuit for decoding an internal code of the data,
   an external code decoding circuit for decoding an external code of the data and inputting the decoded result into the internal code decoding means as a preliminary information of the internal code,
   an error rate calculating circuit for calculating an error rate, and
   a numerical value setting circuit for setting a numerical value required for calculating a data transmission channel to the internal code decoding means,

   wherein the error rate calculating circuit calculates the error rate of each numerical value varied by the numerical value setting circuit, and the numerical value setting circuit determines an optimal numerical value to be set in the internal code decoding circuit based on the error rate calculated.

16. A decoding apparatus for decoding encoded data, comprising:

   an internal code decoding means for decoding an internal code of the data,
   an external code decoding means for decoding an external code of the data and inputting the decoded result into the internal code decoding means as a preliminary information of the internal code,
   an error rate calculating means for calculating an error rate, and
   a numerical value setting means for setting a numerical value required for calculating a data transmission channel to the internal code decoding means,

   wherein the error rate calculating means calculates the error rate of each numerical value varied by the numerical value setting means, and the numerical value setting means determines an optimal numerical value to be set in the internal code decoding means based on the error rate calculated.

17. A reproducing apparatus, comprising:

   a reproducing means for reproducing encoded data from a recording medium,
   a decoding means for decoding the data by a repetitive decoding method,
   a numerical value setting means for setting a numerical value required for calculating a data transmission channel value to the decoding means, and
   an error rate calculating means for calculating an error rate,

   wherein the error rate calculating means calculates the error rate of each numerical value varied by the numerical value setting means, and the numerical value setting means determines an optimal numerical value to be set in the internal code decoding means based on the error rate calculated.

18. A program for making a processor decode data by decoding an internal code of encoded data, decoding an external code of the encoded data, and using the decoded external code as preliminary information of the internal code upon decoding the internal code, the program comprising:

   varying a numerical value required for calculating a data transmission channel value upon decoding the internal code, and
   determining an optimal numerical value to be used upon decoding the internal code based on error rate in each numerical value.

**19.** A recording medium for recording a program for making a processor decode data by decoding an internal code of encoded data, decoding an external code of the encoded data, and using the decoded external code as preliminary information of the internal code upon decoding the internal code, the program comprising:

varying a numerical value required for calculating a data transmission channel value upon decoding the internal code, and
determining an optimal numerical value to be used upon decoding the internal code based on error rate in each numerical value.

F I G. 1

FIG. 2

14

FIG. 3

F I G. 4

F I G. 5

F I G. 6

F I G. 7

<table>
<tr><td colspan="2" align="center">**INTERNATIONAL SEARCH REPORT**</td><td>International application No.<br>PCT/JP03/10953</td></tr>
</table>

| A.  CLASSIFICATION OF SUBJECT MATTER |
|---|
| Int.Cl$^7$  H03M13/29, G11B20/18 |

According to International Patent Classification (IPC) or to both national classification and IPC

| B.  FIELDS SEARCHED |
|---|
| Minimum documentation searched (classification system followed by classification symbols)<br>Int.Cl$^7$  H03M13/00-13/53 |

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2003 |
| Kokai Jitsuyo Shinan Koho | 1971-2003 | Toroku Jitsuyo Shinan Koho | 1994-2003 |

Electronic data base consulted during the international search (name of data base and, where practicable, search terms used)

| C.  DOCUMENTS CONSIDERED TO BE RELEVANT | | |
|---|---|---|
| Category* | Citation of document, with indication, where appropriate, of the relevant passages | Relevant to claim No. |
| P,A | JP 2002-367291 A  (Fujitsu Ltd.),<br>20 December, 2002 (20.12.02),<br>Full text; all drawings<br>& EP 1267345 A          & CN 1391220 A | 1-19 |
| A | JP 2001-285084 A  (Sony Corp.),<br>12 October, 2001 (12.10.01),<br>Page 7, column 11, line 9 to column 12, line 28;<br>Fig. 20<br>(Family: none) | 1-19 |
| P,A | JP 2003-6993 A  (Fujitsu Ltd.),<br>10 January, 2003 (10.01.03),<br>Full text; all drawings<br>(Family: none) | 1-19 |

☐  Further documents are listed in the continuation of Box C.          ☐  See patent family annex.

| | |
|---|---|
| *     Special categories of cited documents:<br>"A"   document defining the general state of the art which is not considered to be of particular relevance<br>"E"   earlier document but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |
| Date of the actual completion of the international search<br>21 November, 2003 (21.11.03) | Date of mailing of the international search report<br>09 December, 2003 (09.12.03) |
| Name and mailing address of the ISA/<br>Japanese Patent Office | Authorized officer |
| Facsimile No. | Telephone No. |

Form PCT/ISA/210 (second sheet) (July 1998)